(19) Europäisches Patentamt
European Patent Office
Office européen des brevets

(11) Numéro de publication : **0 234 984 B1**

(12) **FASCICULE DE BREVET EUROPEEN**

(45) Date de publication du fascicule du brevet : **20.03.91 Bulletin 91/12**

(51) Int. Cl.[5] : **C30B 13/02**, C30B 13/34, C30B 29/48

(21) Numéro de dépôt : **87400125.8**

(22) Date de dépôt : **20.01.87**

(54) **Procédé de préparation d'un lingot cristallin de Hg1-xo Cdxo Te.**

(30) Priorité : **21.01.86 FR 8600769**

(43) Date de publication de la demande : **02.09.87 Bulletin 87/36**

(45) Mention de la délivrance du brevet : **20.03.91 Bulletin 91/12**

(84) Etats contractants désignés : **DE ES GB IT NL**

(56) Documents cités :
**EP-A- 0 060 744**
**EP-A- 0 115 715**
**FR-A- 2 536 767**

(73) Titulaire : **SAT Société Anonyme de Télécommunications**
**41, rue Cantagrel**
**F-75631 Paris Cedex 13 (FR)**

(72) Inventeur : **Durand,Alain René Lucien**
**45 rue Jules Ferry**
**F-86000 Poitiers (FR)**
Inventeur : **Dessus,Jean-Luc**
**9 rue Henri Dunant**
**F-86000 Poitiers (FR)**
Inventeur : **Royer,Michel**
**29 rue Claude Decaen**
**F-75012 Paris (FR)**

(74) Mandataire : **Bloch, Gérard et al**
**2, square de l'Avenue du Bois**
**F-75116 Paris (FR)**

**EP 0 234 984 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un procédé de préparation d'un lingot cristallin de

$$Hg_{1-x_o} Cd_{x_o} Te$$

de composition sensiblement uniforme par la méthode THM ("Travelling Heather Method") dans lequel :

- on dispose, au fond d'une enceinte, sensiblement cylindrique et verticale, un mélange solidifié de Te, Hg Te et Cd Te en proportions correspondant à celles de la phase liquide, à ladite température prédéterminée (T) dudit lingot à préparer,
- on dispose, en contact avec ledit mélange solidifié un lingot-source cylindrique de Hg Te et un lingot-source cylindrique de Cd Te, le rapport de leurs sections respectives étant égal au rapport souhaité Hg/Cd dudit lingot préparé,
- on ferme ladite enceinte, sous vide,
- on chauffe la zone de l'enceinte correspondant audit mélange solidifié, pour faire fondre celui-ci et l'amener à ladite température prédéterminée (T), obtenant ainsi une zone de solvant pour dissoudre les parties desdits lingots-sources en contact avec la zone de solvant, et
- on déplace ladite zone chauffée le long de ladite enceinte, de façon à déplacer ladite zone de solvant et à dissoudre progressivement, à une des extrémités de celle-ci, lesdits lingots-sources, et à obtenir, à son autre extrémité la cristallisation dudit lingot de

$$Hg_{1-x_o} Cd_{x_o} Te$$

à préparer.

Les lingots cristallins ainsi préparés sont utilisés pour fabriquer des détecteurs de rayonnements infrarouge ou encore des diodes à avalanche. De tels dispositifs sont obtenus par des procédés connus de dopage d'un substrat taillé dans un tel lingot.

On connaît déjà un procédé du type défini ci-dessus, décrit dans le brevet français No. 81 05387 au nom de la demanderesse. Ce procédé permet la préparation de lingots cristallins ayant la forme d'un cylindre circulaire de diamètre de l'ordre de vingt millimètres. En découpant un tel cylindre en tranches d'épaisseur appropriée on obtient un grand nombre de disques. Chacun de ces disques constitue une plaquette plane qui, compte tenu de sa surface relativement importante, permet la réalisation simultanée d'un grand nombre de composants électroniques du type ci-dessus, dont la surface est relativement faible. Le disque est ensuite découpé pour permettre de disposer individuellement de chaque composant. Toutefois, une quantité relativement importante de ces composants, présentant des caractéristiques hors tolérance, doit être rejetée. Ceci est du au fait que ces composants, pour fonctionner de façon satisfaisante, doivent être réalisés sur un substrat monocristallin, c'est-à-dire constitué d'un cristal présentant, à l'échelle macroscopique, une orientation et une seule, et ne présentant éventuellement de défauts qu'à l'échelle atomique. Or, le lingot de

$$Hg_{1-x_o} Cd_{x_o} Te$$

obtenu par le procédé mentionné est de structure polycristalline, c'est-à-dire constitué, à l'échelle macroscopique, d'une pluralité de monocristaux d'orientations différentes, de dimensions maximales de l'ordre de 10 mm, séparés par des joints de grains, et présentant des défauts cristallins. Les composants électroniques à rejeter sont ceux qui se trouvent réalisés sur les parties du disque comportant les joints et les défauts. Pour éviter ces rejets dont la conséquence est néfaste sur les coûts de fabrication, il faudrait donc utiliser des disques monocristallins et d'orientation définie.

On connaît par ailleurs un procédé de fabrication d'une couche monocristalline de

$$Hg_{1-x_o} Cd_{x_o} Te,$$

par épitaxie en phase liquide à partir d'un substrat monocristallin de Cd Te, par exemple. Toutefois, l'épaisseur d'une telle couche est limitée à une dizaine de microns et le procédé, qui ne permet de fabriquer qu'une couche à la fois, et nécessite à chaque fois un nouveau germe, est couteux.

On a déjà tenté, afin d'obtenir avec la méthode THM un lingot monocristallin de volume important, d'utiliser un germe monocristallin de Cd Te, par exemple, préalablement disposé au fond de l'enceinte de préparation. Toutefois, on constate dans ce cas, au debut du processus de tirage du lingot, une amorce de dissolution du germe par le solvant qui perturbe l'apparition de l'équilibre de composition qui se réalise normalement du sein de la zone de solvant. Ce phénomène non contrôlé introduit des variations longitudinales de la composition du lingot obtenu, dans lequel subsiste encore une densité importante de défauts cristallins, et parfois des joints de grains. Un dopage au zinc, ou au sélénium, permet de réduire cette densité de défauts cristallins, mais les joints de grains subsistent.

La précédente invention vise à pallier les inconvénients précédents en procurant un procédé de préparation de lingots monocristallins de

$$Hg_{1-x_0} Cd_{x_0} Te$$

dans lesquels la densité de défauts cristallins est encore réduite par rapport au procédé précédent, le diamètre et le volume des lingots préparés étant relativement importants, pour obtenir des plaquettes de grande surface sur lesquelles on peut graver un nombre important des motifs multiéléments rencontrés de plus en plus souvent dans les applications actuelles. A cet effet, elle a pour objet un procédé du type defini ci-dessus, caractérisé par le fait que,

- avant de disposer, au fond de ladite enceinte ledit mélange solidifié, on dispose, au fond de ladite enceinte un germe monocristallin de

$$Hg_{1-x_1} Cd_{x_1} Te$$

tel que :

$$x_0 < x_1 \leq 1$$

ledit germe étant pourvu d'une face plane et polie,

- et que, après avoir disposé ledit mélange solidifié au fond de ladite enceinte, on dispose, en contact avec ledit mélange solidifié un piston de densité inférieure à celle du solvant pourvu d'une base plane, on ferme ladite enceinte, sous vide, sans avoir disposé lesdits lingots-sources à l'intérieur, on chauffe la zone de l'enceinte correspondant audit mélange solidifié pour amener le solvant obtenu à ladite température prédéterminée, pendant la durée nécessaire pour dissoudre la partie dudit germe qui a été écrouie par polissage, puis on refroidit le mélange à vitesse déterminée pour obtenir la cristallisation d'une zone d'adaptation, on ouvre ladite enceinte et on retire ledit piston afin de disposer lesdits lingots sources en contact avec ledit mélange solidifié.

Dans le procédé de l'invention, le lingot obtenu est monocristallin. Ce résultat est obtenu car, au cours d'une étape préalable à l'étape de tirage du lingot, et distincte de celle-ci, on réalise, par chauffage, sans déplacement de la zone chauffée, un équilibre parfait de la composition dans la zone de solvant en présence du germe, puis par refroidissement, la cristallisation d'une zone d'adaptation dans laquelle la variation des paramètres du cristal est continue. Lorsque cette étape est terminée, on procède au tirage, au cours duquel et de façon connue, on réalise l'équilibre, à la température prédéterminée, de la composition de la zone de solvant avec les lingots-sources, qui s'y dissolvent dans des proportions constantes. Le lingot de

$$Hg_{1-x_0} Cd_{x_0} Te$$

qui se cristallise à l'arrière de la zone de solvant a une structure monocristalline amorcée par le germe, par l'intermédiaire de la zone d'adaptation. Par ailleurs, l'ajustement réalisé par cette dernière confère au lingot réalisé un profil longitudinal de composition dont les variations sont plus faibles que dans le procédé connu.

Avantageusement, ledit mélange solidifié étant pourvu d'une face plane, lorsqu'on le dispose au fond de ladite enceinte, on dispose sa face plane contre ladite face plane et polie dudit germe.

Avantageusement encore, et comme dans le procédé THM décrit dans le brevet cité, ledit mélange solidifié pourvu d'une face plane est préparé en chauffant, dans ladite enceinte fermée, les constituants solides dudit mélange, disposés sous ledit piston, jusqu'à ce qu'ils soient fondus, ledit mélange étant sorti de ladite enceinte après solidification.

Il est possible de mettre en oeuvre le procédé de l'invention en utilisant un germe massif, ou un germe obtenu par épitaxie sur un substrat de nature différente.

Afin d'obtenir plusieurs lingots présentant rigoureusement la même composition, on peut utiliser le même germe pour la préparation de ces lingots.

L'invention sera mieux comprise à la lecture de la description suivante de la mise en oeuvre préférée du procédé de l'invention, faite en se référant aux dessins annexés, sur lesquels,

- la figure 1 illustre schématiquement une première phase de la préparation d'un lingot par le procédé THM connu,
- la figure 2 illustre schématiquement une deuxième phase du procédé de la figure 1,
- la figure 3 illustre la préparation de la zone de solvant nécessaire dans le procédé de la figure 1,
- la figure 4 illustre schématiquement une première phase du procédé de l'invention, et
- la figure 5 illustre schématiquement une deuxième phase du procédé de la figure 4.

Le procédé de l'invention de préparation d'un lingot monocristallin de

$$Hg_{1-x_0} Cd_{x_0} Te$$

met en particulier en oeuvre le procédé connu dit THM ("Travelling Heather Method") décrit dans le brevet français No. 81 05387 au nom de la demanderesse à propos de la préparation d'un lingot polycristallin de

$$Hg_{1-x_0}Cd_{x_0}Te,$$

procédé qui est maintenant brièvement rappelé.

Dans le procédé connu, et comme le montre la figure 1, un dispositif annulaire de chauffage 4, comprenant un enroulement conducteur, entoure localement une enceinte 1 sensiblement cylindrique. L'enceinte 1, en matière réfractaire et hermétiquement fermée, est d'axe vertical et contient, dans sa partie supérieure, un lingot source 2 de Hg Te et un lingot source 3 de Cd Te, ces deux lingots étant cylindriques, de sections $S_2$ et $S_3$ quelconques mais constantes et d'axe vertical. Les sections $S_2$ et $S_3$ sont telles que :

$$x_0 = S_3 / (S_2 + S_3) \quad (1)$$

c'est à dire :

$$S_2 / S_3 = (1 - x_0) / x_0 \quad (2)$$

Les parties inférieures des lingots sources 2 et 3 se trouvent dissoutes dans une zone 5 de solvant porté à une température T par le dispositif annulaire de chauffage 4. L'enceinte 1 est alors mise en mouvement vertical de descente, à une vitesse très lente, de l'ordre de quelques millimètres par jour, et par exemple de 100 microns par heure. Comme le montre la figure 2, dans la partie inférieure de la zone 5 qui se refroidit après passage du dispositif annulaire 4, il se produit une recristallisation qui donne naissance à un lingot unique 6 polycristallin de

$$Hg_{1-x_0}Cd_{x_0}Te.$$

Cette étape est appelé étape de tirage du lingot.

Dans ce procédé connu, la température T de chauffage du solvant est comprise entre 600 et 700°C. Lorsque $x_0$ est voisine de 650°C et lorsqu'il est supérieur à 0,5 on choisit de préférence une température T voisine de 700°C.

Afin d'obtenir un lingot polycristallin de

$$Hg_{1-x_0}Cd_{x_0}Te$$

dans lequel $x_0$ soit constant sur toute la longueur, le brevet cité prévoit l'utilisation d'un solvant riche en tellure contenant Hg Te, Cd Te et Te dans des proportions déterminées par example empiriquement de la façon suivante.

Après avoir choisi la température T de chauffage du solvant, on procède à la préparation d'un lingot polycristallin en utilisant comme solvant de départ du tellure pur, pour deux lingots sources de Hg Te et de Cd Te, de sections dans un rapport correspondant à $x_0$ selon les équations (1) et (2). Comme on utilise du tellure pur comme solvant de départ, la composition du lingot de $Hg_{1-x}Cd_xTe$ n'est pas constante sur toute sa longueur, la tête du lingot, c'est à dire la partie qui a été cristallisée en premier après passage de la zone de solvant étant trop riche en cadmium, c'est-dire-telle que :

$$x > x_0 \quad (3)$$

Cependant, au fur et à mesure que l'enceinte descend par rapport au dispositif de chauffage fixe, la zone de solvant, correspondant au départ à du tellure pur, ensuite enrichi de Cd Te et de Hg Te dans un rapport égal à celui des sections des lingots sources, va s'appauvrir progressivement en cadmium et s'enrichir en mercure pour arriver finalement à une composition d'équilibre, telle que la zone de solvant, portée à la température T, et alimentée en Hg Te et en Cd Te dans le rapport des sections des lingots sources, lié à $x_0$, donne naissance à un lingot dont la composition x est égale à $x_0$. Cette composition correspondante à celle de la phase liquide, à la température T, du lingot de composition $x_0$.

Cette composition pourrait être déterminée théoriquement compte tenu de la température T et du rapport $x_0$ souhaité, mais il est possible de la déterminer empiriquement en refroidissement brutalement la zone de solvant au bout d'un temps de tirage suffisant pour qu'on soit certain d'être parvenu dans une zone de lingot ou x est égal à $x_0$. On procède alors à une analyse de la zone de solvant.

A titre d'exemple, pour T = 700°C et $x_0$ = 0,7 on trouve :

Te = 68% molaire
CdTe = 2% molaire
HgTe = 30% molaire

Pour T = 650°C et $x_0$ = 0,2, on trouve :

Te = 32,5% molaire
CdTe = 4% molaire
HgTe = 63,5% molaire

Après cette étape préliminaire de détermination de la composition du solvant, on prépare ce dernier comme décrit dans le brevet déjà cité, c'est-à-dire en plaçant dans l'enceinte 1, ici à fond plat, du tellure Te, du tellurure de mercure Hg Te et du tellurure de cadmium Cd Te, sous forme de morceaux solides. Comme le montre la figure 3, on dispose sur ces produits un piston 10 de quartz pourvu d'une base plane, on fait le vide grâce à la vanne 11, on introduit un gaz neutre sous pression de 2 à 3 atmosphères, et on chauffe les produits dans un four 12, à une température suffisante pour les faire fondre.

Le piston 10 flotte sur le mélange fondu car il est de densité inférieure à celle de celui-ci. Après deux à

trois heures, on arrête le chauffage et le mélange 13 se solidifie, en présentant, grâce à la base plane du piston 10, une face 14 supérieure bien plane.

Dans le procédé de préparation de lingots polycristallins décrit dans le brevet cité, on ouvre l'enceinte 1 qui a servi à préparer le mélange solidifié 13, on retire le piston 10, on introduit des lingots-sources et on procède, après chauffage du mélange solidifié 13 pour obtenir le solvant 5, à une opération de tirage d'un lingot polycristallin de composition homogène sur toute sa longueur, avec $X = x_0$.

Dans le procédé de préparation qui va maintenant être décrit, qui permet de préparer un lingot monocristallin de

$$Hg_{1-x_0}\ Cd_{x_0}\ Te,$$

ou $x_0$ est compris entre 0 et 1, l'étape de tirage du lingot est identique à celle qui vient d'être décrite. Elle est précédée d'une étape préléminaire qui va mainteant être décrite.

Cette étape comprend d'abord la préparation d'un germe massif, monocristallin, de

$$Hg_{1-x_1}\ Cd_{x_1}\ Te$$

où $x_1$ est tel que

$$x_0 < x_1 \leq 1$$

A titre d'exemple, pour $x_0 = 0,2$, on peut choisir $x_1 = 0,22$.

Ce germe est obtenu soit à partir d'un bloc monocristallin disponible dans un polycristal ou encore par le procédé de l'invention, comme cela sera vu par la suite. Comme le montre la figure 4, ce germe est usiné pour avoir la forme d'un disque 15, dont une face 16 est polie et orientée par rapport à l'orientation du cristal (100 ou 111). Il est disposé au fond de l'enceinte 1 dont il a sensiblement la forme, et la face polie 16 est dirigée vers le haut. On dispose par dessus un bloc de solvant 13, préparé comme dans le procédé connu, de façon à ce que la face plane 14 du bloc se trouve en contact avec la face 16 plane et polie du germe 15. On place par dessus le piston de quartz 10 et on ferme l'enceinte 1 sous vide. L'enceinte 1 étant maintenue immobile, on chauffe le bloc de solvant à la température T à l'aide du dispositif de chauffage 4 pendant une durée suffisante pour dissoudre le germe sur une épaisseur de quelques dizaines de microns. A titre indicatif cette durée est de l'ordre de une heure pour une température T de 650°, un germe en tellure de cadmium Cd Te et le solvant dont la composition a été précisée plus haut.

Cette opération a pour but la dissolution de la zone qui a été écrouie par le polissage de la face 16 du germe 15, qui présente des dislocations et des impuretés dues au traitement mécanique. Après ce chauffage, la première couche non dissoute du germe 15 monocristallin est une couche ne présentant aucun défaut et parfaitement propre.

Après l'opération de chauffage précédente on refroidit la zone chauffée à une vitesse déterminée, inférieure à la vitesse de refroidissement qui est celle de la zone de solvant 5 lors de l'opération de tirage déjà décrite. Il y a alors cristallisation d'une zone d'adaptation, ou interface de cristallisation, au voisinage du germe 15. A l'intérieur de cette zone d'adaptation monocristalline, il y a une variation continue de la distance interatomes, c'est-à-dire du paramètre de maille, ainsi que des autres paramètres du cristal, comme les coefficients de température, dilatation et conduction par exemple.

La vitesse de refroidissement, déterminée expérimentalement, influe sur la formation de cette zone d'adaptation. Si elle est trop rapide, des défauts cristallins apparaissent dans la zone solidifiée, si elle est trop lente, la ségrégation continue, et la zone d'adaptation disparait au profit d'une inhomogénéité du cristal.

Après refroidissement complet du contenu de l'enceinte 1, l'étape préliminaire est terminée, et, après ouverture de l'enceinte 1, on retire le piston 10 et on dispose les lingots-sources 2 et 3 de Hg Te et de Cd Te comme le procédé connu.

Après avoir refermé l'enceinte 1 sous vide, on chauffe le mélange solidifie 13 jusqu'à atteindre l'équilibre à la température T du solvant 5 avec les lingots-sources et on déplace alors l'enceinte, comme le montre la figure 5, pour procéder au tirage du lingot 6 comme dans le procédé connu. Grâce à la zone d'adaptation 18 le lingot 6 est d'une part monocristallin et d'autre part présente une très bonne homogénéité radiale et longitudinale de composition.

Il est possible de prévoir une enceinte de diamètre légèrement supérieur au diamètre du germe, le raccordement se faisant par une partie tronconique.

On peut ainsi obtenir un lingot monocristallin de diamètre légèrement supérieur à celui du germe, dans lequel on peut tailler un nouveau germe de diamètre supérieur. Ainsi en procédant de proche en proche, et à partir d'un premier germe disponible à l'état naturel dans un lingot polycristallin on obtient des germes et des lingots de diamètre de plus en plus grand. La longueur du lingot n'est limitée que par les possibilités de l'installation.

A titre d'exemple, pour $x_0 = 0,2$, la demanderesse a obtenu des lingots de 20, 30 et 40 mm de diamètre et de 60 mm de longueur, avec une dispersion sur la valeur de $x_0$ telle que $x_0 = 0,200 \pm 0,007$ sur la longueur, et $x_0 = 0,2000 \pm 0,0015$ sur le diamètre.

Dans la description précédente, on utilise un germe monocristallin massif. Ceci n'est pas obligatoire et on peut également utiliser un germe monocristallin obtenu par épitaxie sur un substrat de nature différente, comme par exemple de l'arsenure de gallium, ou du saphir.

Si on le désire, et afin d'obtenir un ensemble de lingots de composition rigoureusement uniforme, on peut réaliser un premier lingot à partir d'un certain germe, découper la base du premier lingot pour récupérer le germe, et ainsi de suite, de façon à obtenir plusieurs lingots préparés à partir du même germe.

## Revendications

1. Procédé de préparation d'un lingot cristallin (6) de

$$Hg_{1-x_0}Cd_{x_0}Te$$

de composition sensiblement uniforme par la méthode THM ("Travelling Heather Method ") dans lequel :

- on dispose, au fond d'une enceinte (1), sensiblement cylindrique et verticale, un mélange solidifié (13) de Te, Hg Te et Cd Te en proportion correspondant à celles de la phase liquide, à ladite température prédéterminée (T) dudit lingot à préparer,
- on dispose, en contact avec ledit mélange solidifié (13) un lingot-source (2) cylindrique de Hg Te et un lingot-source (3) cylindrique de Cd Te, le rapport de leurs sections respectives ($S_2/S_3$) étant égal au rapport souhaité Hg/Cd ($(1 - x_0)/x_0$) dudit lingot à préparer,
- on ferme ladite enceinte (1), sous vide,
- on chauffe la zone de l'enceinte (1) correspondant audit mélange solidifié (13), pour faire fondre celui-ci et l'amener à ladite température prédéterminée (T), obtenant ainsi une zone de solvant (5) pour dissoudre les parties desdits lingots-sources (2, 3) en contact avec la zone de solvant, et
- on déplace ladite zone chauffée le long de ladite enceinte (1), de façon à déplacer ladite zone de solvant (5) et à dissoudre progressivement, à une des extrémités de celle-ci (5), lesdits lingots-sources (2, 3), et à obtenir, à son autre extrémité la cristallin dudit lingot (6) de

$$Hg_{1-x_0}Cd_{x_0}Te$$

à préparer

procédé caractérisé par le fait que,

- avant de disposer, au fond de ladite enceinte (1) ledit mélange solidifié (13), on dispose, au fond de ladite enceinte (1) un germe monocristallin (15) de

$$Hg_{1-x_1}Cd_{x_1}Te$$

tel que :

$$x_0 < x_1 \leq 1$$

ledit germe (15) étant pourvu d'une face (16) plane et polie,
- et que, après avoir disposé ledit mélange solidifié (13) au fond de ladite enceinte (1), on dispose, en contact avec ledit mélange solidifié (13) un piston (10) de densité inférieur à celle du solvant (5) pourvu d'une base plane, on ferme ladite enceinte, sous vide, sans avoir disposé lesdits lingots-sources (2, 3) à l'intérieur, on chauffe la zone de l'enceinte (1) correspondant audit mélange solidifié (13) pour amener le solvant (5) obtenu à ladite température prédéterminé (T), pendant la durée nécessaire pour dissoudre la partie dudit germe (15) qui a été écrouie par polissage, puis on refroidit le mélange à vitesse déterminée pour obtenir la cristallisation d'une zone d'adaptation (18), on ouvre ladite enceinte (1) et on retire ledit piston (10) afin de disposer lesdits lingots sources (2, 3) en contact avec ledit mélange solidifié (13).

2. Procédé selon la revendication 1, dans lequel ledit mélange solidifié (13) étant pourvu d'une face (14) plane, lorsqu'on le dispose au fond de ladite enceinte (1), on dispose sa face (14) plane contre ladite face (16) plane et polie dudit germe (15).

3. Procédé selon l'une des revendications 1 et 2, dans lequel ledit mélange solidifié (13) pourvu d'une face (14) plane est préparé en chauffant, dans ladite enceinte (1) fermée, les constituants solides dudit mélange (13), disposés sous ledit piston (10), jusqu'à ce qu'ils soient fondus, ledit mélange (13) étant sorti de ladite enceinte (1) après solidification.

4. Procédé selon l'une des revendications 1 à 3, dans lequel ledit germe est obtenu par épitaxie sur un substrat de nature différente.

5. Procédé selon l'une des revendications 1 à 3, dans lequel on utilise le même germe pour la préparation de plusieurs lingots.

6. Procédé selon l'une des revendications 3 à 5, dans lequel la fusion des constituants dudit mélange (13) se fait en atmosphère de gaz neutre.

7. Procédé selon l'une des revendications 1 à 6, dans lequel ladite température prédéterminée (T) est comprise entre sensiblement 600°C et sensiblement 700°C.

8. Procédé selon l'une des revendications 1 à 7, dans lequel $x_0 = 0,2$ et $x_1 = 0,22$, ladite température prédéterminée (T) est de 650°C et la composition dudit mélange solidifié (13) est sensiblement :

Te =32,5% molaire
CdTe =54% molaire
HgTe =63,5% molaire

## Ansprüche

1. Verfahren zur Herstellung eines kristallinen Stabes (6) aus $Hg_{1-x0}$ $Cd_{x0}$ Te mit im wesentlichen gleichmäßiger Zusammensetzung nach dem THM-Verfahren ("Traveling Heather Method"), bei welchem :

- man am Grund einer im wesentlichen zylindrischen und vertikalen Hohlform (1) eine festgewordene Mischung (13) aus Te, HgTe und CdTe in einem den Verhältnissen der flüssigen Phase des herzustellenden Stabes bei der vorherbestimmten Temperatur (T) entsprechenden Verhältnis vorlegt,
- man im Kontakt mit dieser festgewordenen Mischung (13) einen zylindrischen Spenderstab (2) aus HgTe und einen zylindrischen Spenderstab (3) aus CdTe vorsieht, deren jeweilige Querschnitte in einem Verhältnis ($S_2/S_3$) zu einander stehen, das dem gewünschten Verhältnis Hg/Cd ($(1-X_0)/X_0$) des herzustellenden Stabes gleich ist,
- man die genannte Hohlform (1) unter Vakuum verschließt,
- man jenen Bereich der Hohlform (1), der der genannten festgewordenen Mischung (13) entspricht, erhitzt, um diese aufzuschmelzen und auf die vorherbestimmte Temperatur (T) zu bringen, wodurch man einen Bereich eines Lösungsmittels (5) erhält, in dem die Teile der Spenderstäbe (2, 3), die sich im Kontakt mit der Lösungsmittelzone befinden, aufgelöst werden, und
- man diese erhitzte Zone entlang der Hohlform (1) derart verschiebt, daß der Bereich von Lösungsmittel (5) verschoben wird, die Spenderstäbe (2, 3) in zunehmendem Maße an einem Ende dieses Bereiches (5) gelöst werden und an seinem anderen Ende Kristallisation des herzustellenden Stabes (6) aus $Hg_{1-x0}$ $Cd_{x0}$ Te bewirkt wird, welches Verfahren dadurch gekennzeichnet ist, daß
- man vor dem Einbringen der festgewordenen Mischung (13) am Grund der Hohlform (1) am Boden derselben einen monokristallinen Keim (15) aus $Hg_{1-x1}$ $Cd_{x1}$ Te mit

$$X_0 < X1 \leq 1$$

einsetzt, welcher eine ebene und polierte Fläche (16) hat, und daß
- man nach dem Einbringen der festgewordenen Mischung (13) am Grund der Hohlform (1) im Kontakt mit der festgewordenen Mischung (13) einen Kolben (10) mit geringerer Dichte als der des Lösungsmittels (5) und mit einer ebenen Grundfläche einsetzt, daß man die Hohlform unter Vakuum schließt, ohne die beiden Spenderstäbe (2, 3) im Inneren eingesetzt zu haben, daß man jenen Bereich der Hohlform (1), der der verfestigten Mischung (13) entspricht, erhitzt, um das erhaltene Lösungsmittel (5) während jenes Zeitraums auf die vorherbestimmte Temperatur (T) zu bringen, der zum Auflösen jenes Teils des Keims (15) notwendig ist, der durch Polieren gehärtet wurde, worauf man die Mischung mit einer bestimmten Geschwindigkeit abkühlt, um die Kristallisation einer Anpassungszone (18) zu bewirken, die Hohlform (1) öffnet und den genannten Kolben (10) hochzieht, um die genannten Spenderstäbe (2, 3) in Kontakt mit der verfestigten Mischung (13) zu bringen.

2. Verfahren nach Anspruch 1, bei welchem man die genannte verfestigte Mischung (13), die mit einer ebenen Fläche (14) versehen ist, wenn sie am Boden der genannten Hohlform (1) vorgesehen ist, mit ihrer Fläche (14) gegen die ebene und polierte Fläche (16) des genannten Keimes (15) richtet.

3. Verfahren nach einem der Anspruche 1 oder 2, bei welchem die genannte verfestigte Mischung (13), die mit einer ebenen Fläche (14) versehen ist, dadurch hergestellt wird, daß man in der geschlossenen Hohlform (1) die festen Bestandteile der Mischung (13), die unter dem genannten Kolben (10) angeordnet ist, so lange erhitzt, bis sie geschmolzen sind, worauf nach der Verfestigung die genannte Mischung (13) aus der Hohlform (1) entnommen wird.

4. Verfahren nach einem der Ansprüche 1 bis 3, bei welchem der genannte Keim durch Epitaxie auf einem Substrat unterschiedlicher Art erhalten wird.

5. Verfahren nach einem der Ansprüche 1 bis 3, bei welchem man den gleichen Keim für die Herstellung mehrerer Stäbe verwendet.

6. Verfahren nach einem der Ansprüche 3 bis 5, bei welchem das Aufschmelzen der Bestandteile der genannten Mischung (13) unter Inertgasatmosphäre erfolgt.

7. Verfahren nach einem der Ansprüche 1 bis 6, bei welchem die genannte vorherbestimmte Temperatur (T) im wesentlichen zwischen 600°C und 700°C liegt.

8. Verfahren nach einem der Ansprüche 1 bis 7, bei welchem $X_0 = 0{,}2$ und $X_1 = 0{,}22$, die vorherbestimmte Temperatur (T) 650°C beträgt und die Zusammensetzung der verfestigten Mischung (13) im wesentlichen die folgende ist:

Te =32,5 Mol%
CdTe =54 Mol%
HgTe =63,5 Mol%

## Claims

1. Method of preparing a crystalline ingot (6) of

$$Hg_{1-x_0} Cd_{x_0} Te$$

of a substantially uniform composition using the THM method (Traveling Heather Method) in which ;

– at the bottom of a substantially cylindrical and vertical enclosure (1) is disposed a solidified mixture (13) of Te, Hg Te and Cd Te in proportions corresponding to those of the liquid phase, at said predetermined temperature (T) of said ingot to be prepared,

– in contact with said solidified mixture (13) is disposed a cylindrical source ingot (2) of Hg Te and a cylindrical source ingot (3) of Cd Te, the ratio of their respective sections ($S_2/S_3$) being equal to the desired Hg/Cd ratio ($(1-x_0)/x_0$) of said ingot to be prepared,

– said enclosure (1) is closed under a vacuum,

– the zone of the enclosure (1) corresponding to said solidified mixture (13) is heated for melting this latter and bringing it to said predetermined temperature (T), thus obtaining a solvent zone (5) for dissolving the parts of said source ingots (2, 3) in contact with the solvent zone, and

– said heated zone is moved along said enclosure (1) so as to move said solvent zone (5) and to progressively dissolve, at one of the ends thereof, said source ingots (2, 3) and to obtain, at its other end, the crystallization of said

$$Hg_{1-x_0} Cd_{x_0} Te$$

ingot (6) to be prepared, method characterized in that,

– before disposing said solidified mixture (13) at the bottom of said enclosure (1), a monocrystalline germ (15) of

$$Hg_{1-x_1} Cd_{x_1} Te$$

is disposed at the bottom of said enclosure (1) such that :

$$x_0 < x_1 \leq 1$$

said germ (15) being provided with a flat and polished face (16),

– and, after disposing said solidified mixture (13) at the bottom of said enclosure (1), a piston (10) having a density less than that of the solvent (5) provided with a flat base is disposed in contact with said solidified mixture (13), said enclosure is closed under a vacuum without disposing said source ingots (2, 3) inside, the zone of the enclosure (1) is heated corresponding to said solidified mixture (13) so as to bring the solvent (5) obtained to said predetermined temperature (T), for the time necessary for dissolving the part of said germ (15) which has been work hardened by polishing, then the mixture is cooled at a given rate so as to obtain crystallization of an adaptation zone (18), said enclosure (1) is opened and said piston (10) is withdrawn so as to dispose said source ingots (2, 3) in contact with said solidified mixture (13).

2. Method according to claim 1, wherein said solidified mixture (13), having a flat face (14), when it is disposed at the bottom of said enclosure (1) is disposed with its flat face (14) against said flat and polished face (16) of said germ (15).

3. Method according to one of claims 1 and 2, wherein said solidified mixture (13) having a flat face (14) is prepared by heating, in said closed enclosure (1), the solid constituents of said mixture (13) disposed under said piston (10) until they are melted, said mixture (13) being removed from said enclosure (1) after solidification.

4. Method according to one of claims 1 to 3, wherein said germ is obtained by epitaxy on a substrate of a different nature.

5. Method according to one of claims 1 to 3, wherein the same germ is used for preparing several ingots.

6. Method according to one of claims 3 to 5, wherein melting of the constituents of said mixture (13) takes place in a neutral gas atmosphere.

7. Method according to one of claims 1 to 6, wherein said predetermined temperature (T) is substantially between 600°C and substantially 700°C.

8. Method according to one of claims 1 to 7, wherein $x_0 = 0.2$ and $x_1 = 0.22$, said predetermined temperature (T) is 650°C and the composition of said solidified mixture (13) is substantially :

Te =32.5 molar %
CdTe =54 molar %
HgTe =63.5 molar %

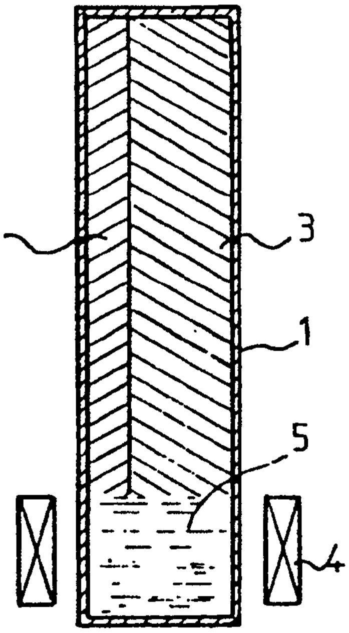


FIG.1

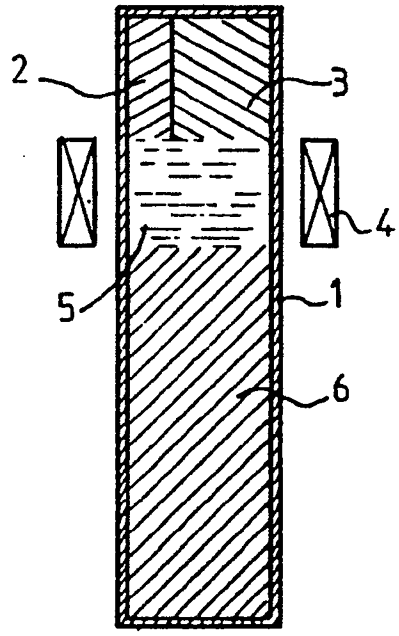


FIG.2

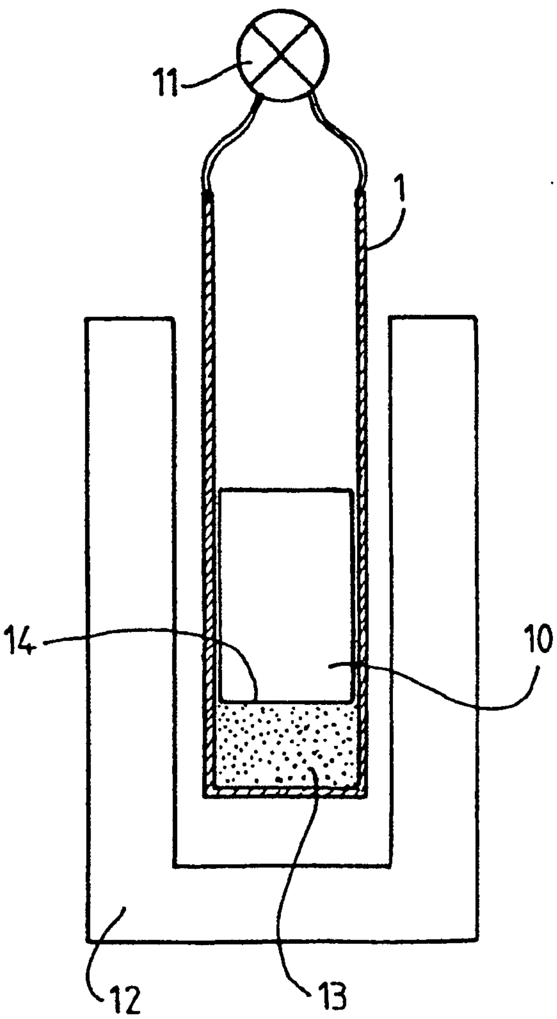


FIG. 3

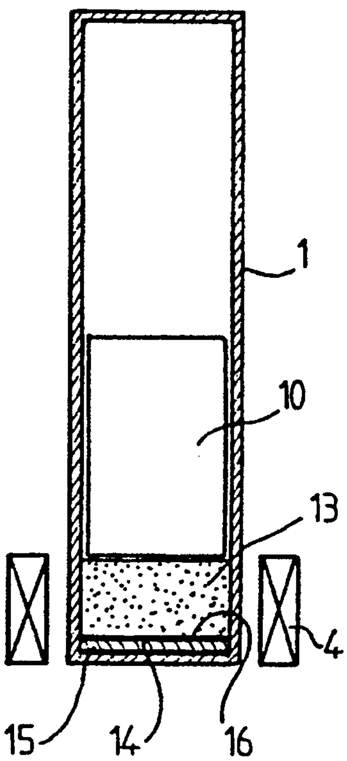


FIG. 4

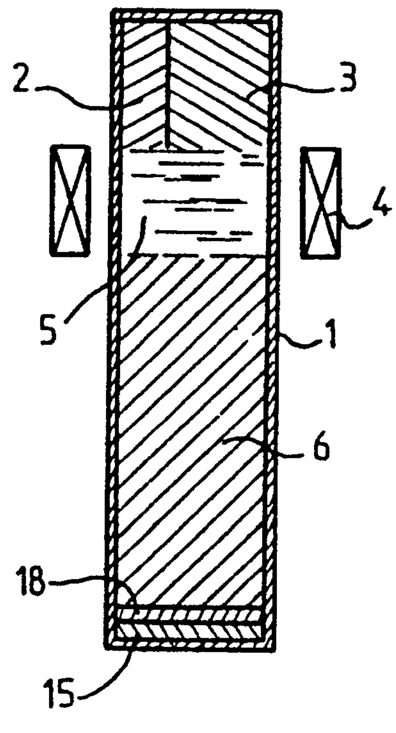


FIG. 5